**Europäisches Patentamt**

**European Patent Office**

**Office européen des brevets**

(11) Publication number: **0 113 216**
**B1**

## EUROPEAN PATENT SPECIFICATION

(45) Date of publication of patent specification: **12.07.89**  (51) Int. Cl.⁴: **H 03 M 1/78**

(21) Application number: **83307559.1**

(22) Date of filing: **13.12.83**

(54) **Digital analog converter.**

(30) Priority: **29.12.82 JP 233909/82**

(43) Date of publication of application:
**11.07.84 Bulletin 84/28**

(45) Publication of the grant of the patent:
**12.07.89 Bulletin 89/28**

(84) Designated Contracting States:
**DE FR GB**

(56) References cited:
**EP-A-0 026 579**
**EP-A-0 028 695**
**FR-A-2 288 424**
**US-A-3 541 354**
**US-A-3 832 707**

**IEEE JOURNAL OF SOLID-STATE CIRCUITS,**
**vol. SC-11, no. 6, December 1976, pages**
**789-794, IEEE, New York, US; J.J. PRICE: "A**
**passive laser-trimming technique to improve**
**the linearity of a 10-bit D/A converter"**

(73) Proprietor: **FUJITSU LIMITED**
**1015, Kamikodanaka Nakahara-ku**
**Kawasaki-shi Kanagawa 211 (JP)**

(72) Inventor: **Hino, Youzi c/o Fujitsu Limited**
**Patent Department 1015 Kamikodanaka**
**Nakahara-ku Kawasaki-shi Kanagawa 211 (JP)**

(74) Representative: **Sunderland, James Harry et al**
**HASELTINE LAKE & CO Hazlitt Housew**
**28 Southampton Buildings Chancery Lane**
**London WC2A 1AT (GB)**

Courier Press, Leamington Spa, England.

## Description

The present invention relates to a digital-analog converter, and is particularly concerned with a digital analog converter which is fabricated in an integrated circuit (IC).

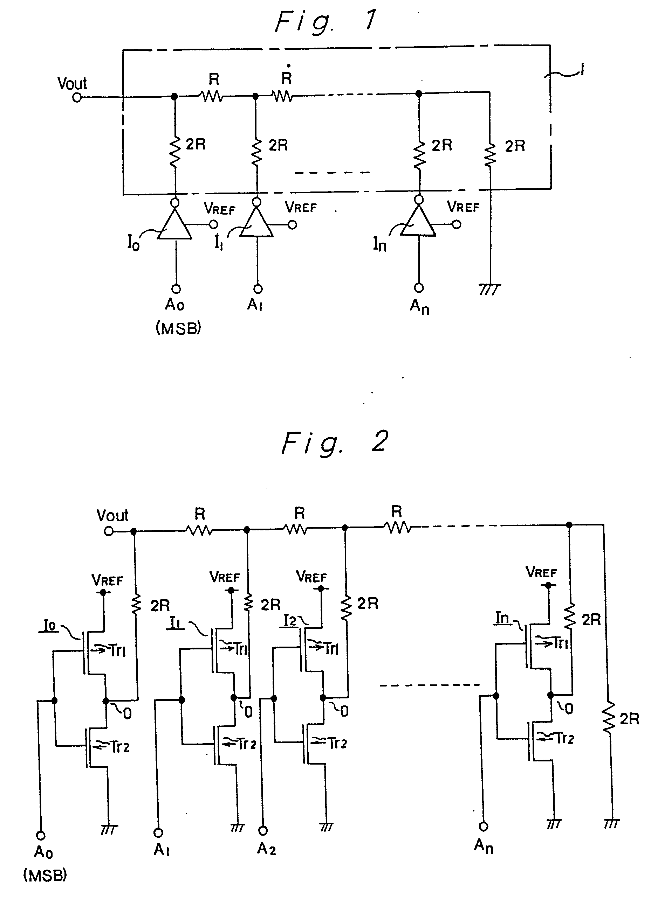

Many D/A converter circuits have been proposed, for converting digital signals to analog signals. In general such circuits have a ladder circuit configuration as shown in Fig. 1 of the accompanying drawings, which is a schematic block circuit diagram of a D/A converter. When an input digital signal, made up of bit signals ($A_0$, $A_1$, $A_2$,...$A_n$), is applied to the D/A converter circuit, each bit signal controls a corresponding switch ($I_0$, $I_1$, $I_2$,...$I_n$), each switch being an inverter for example. A reference voltage $V_{REF}$, or a ground voltage is delivered from the output terminal of each switch $I_0$, $I_1$, $I_2$,...$I_n$.

Ladder circuit 1 in Fig. 1 is constructed by using two kinds or values of resistor, R and 2R, connected to one another as shown in the Figure. The resistance of resistors 2R is twice that of the resistors R. The circuit configuration shown is therefore, sometimes called a R-2R ladder network. It will be understood that the combined impedance at each branch point of the ladder circuit 1, looking towards the right in Figure 1, is equal to R. Thus, if each of the branches 2R is connected to a reference voltage source $V_{REF}$, through the corresponding switch, the output voltage $V_{out}$ of the ladder circuit is:—

$$V_{out}=V_{REF}(A_0/2+A_1/2^2+A_2/2^3+...+A_n/2^n) \quad (1)$$

As can be appreciated from Figure 1 and the above equation, each bit applied to a switch contributes to the output voltage in accordance with the order or significance specified for that bit. $A_0$ is the most significant bit (MSB), and $A_n$ is the least significant bit (LSB) in Fig. 1.

Fig. 2 of the accompanying drawings is a schematic circuit diagram of a realization of the circuit of Fig. 1 on an IC die. The circuit is formed with a ladder circuit configuration using resistors R and 2R, and inverter circuits $I_0$, $I_1$, $I_2$,...$I_n$ constituted by complementary MOS (metal oxide semiconductor) transistors.

Each inverter circuit has its own input terminal $A_0$, $A_1$, $A_2$,...$A_n$, and is constituted by a p-type and an n-type MOS transistor, the gate electrodes of these two transistors being connected to each other and commonly connected to the respective input terminal. The drain electrode of the p-type MOS transistor of the inverter and the source electrode of the n-type MOS transistor of the inverter are connected to one another at a point 0 (common point), and commonly connected to one end of a respective resistor 2R. The source electrode of the p-type MOS transistor and the drain electrode of the n-type MOS transistor are connected respectively to a reference voltage source $V_{REF}$ and to ground.

The other ends of the resistors 2R (ends not connected to common points 0) are linked to respective branch points with resistors R. The end (right-hand end in Fig. 2) of the ladder circuit is grounded through a terminating resistor 2R.

An input digital signal, which will usually be stored in a register or supplied directly from a logic circuit (not shown), is fed to the D/A converter circuit. Each bit of the input digital signal is separately supplied to a corresponding input terminal of one of the inverter circuits. It should be pointed out that the same notations is applied to the input terminals of the inverter circuits and to the bits of the input signal ($A_0$, $A_1$, $A_2$,...$A_n$). Thus, the first bit $A_0$ (that is, the MSB) is supplied to the first inverter circuit $I_0$, the second most significant bit $A_1$ is supplied to the second inverter circuit $I_1$, and so on. The least significant bit $A_n$ is supplied to the last inverter switching circuit $I_n$.

Each inverter circuit, depending whether its input terminal is supplied with a "0" or a "1" signal in correspondance to the code of the input signal as a whole, supplies the reference voltage $V_{REF}$ or the ground (0) voltage to the associated branch or junction point through the associated resistor 2R.

For example, if the input digital signal is (1, 1, 1,...1), that is, all bits are "1", namely $A_0=A_1=A_2=...=A_n=1$, all inverters are supplied with a "1" signal, and the gate potentials of all transistors in the inverter circuits go up. Thus, p-channel type MOS transistors (p-MOS) are pinched "off", and n-channel type MOS transistors (n-MOS) are conductive and achieve an "on" state. Therefore, common points 0 all receive ground potential.

On the other hand, if the input digital signal is (0, 0,...0), all inverters are supplied with "0" signals, and the gate potentials of all transistors in the inverter circuits become low. Thus the p-MOS's achieve an "on" state, and the n-MOS's take an "off" state. Therefore, the common points 0 all receive the reference voltage $V_{REF}$.

The output voltage $V_{out}$ is an accumulation of the potentials of all the common points weighted according to the significance of the bits of the input digital signal related to those points. This is expressed mathematically by equation (1).

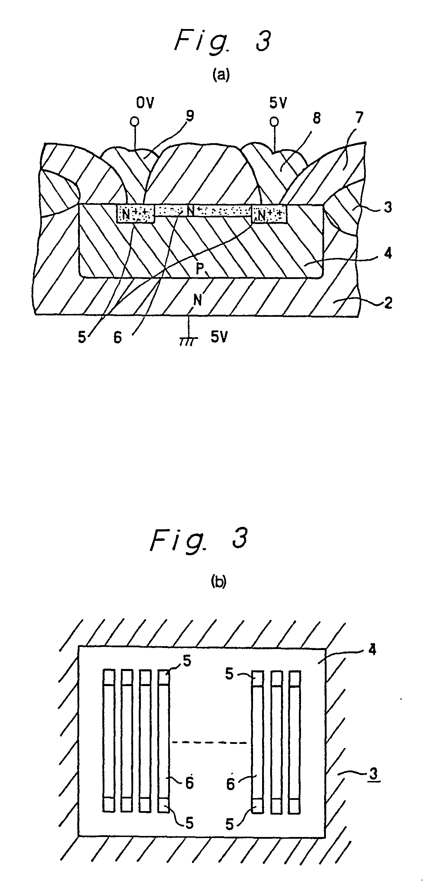

Fig. 3 of the accompanying drawings illustrates an example of a resistor, fabricated of semiconductor, which is widely used for the resistance network of D/A converters, Fig. 3 (a) is a cross sectional view of a resistor, and Fig. 3(b) is a plan view of a number of resistors illustrating their alignment. In the Figures, 2 is a substrate of an IC die (or chip), which is of n-type silicon for example.

It will be clear that the substrate may be of p-type silicon, or of any other type of semiconductor as appropriate, but the following description will be given mainly with respect to n-type silicon substrate.

Processes for fabricating resistors are common and popularly employed. The details of such processes are not directly related to the present invention but such a process will be explained briefly, to illustrate and explain the structure of a resistor.

After fabricating a field oxide layer 3, a p-type well 4 is formed in the substrate 2. In the well 4, terminal electrodes 5 are fabricated by diffusion of a very high dose of n-type dopant. Such very highly doped regions are often called N$^{++}$ regions. Between the N$^{++}$ regions, a region N$^+$6, which is highly doped with n-type dopant, is fabricated and constitutes a resistor.

A number of such resistors, each having a strip form, can be arranged in parallel to each other as shown in Fig. 3(b). The resistance value of a resistor is determined by the size of the strip and the resistivity of the N$^+$ region 6 of the resistor.

It is well known that

$$R=R_a \, l/w \qquad (2)$$

where, $R_a$ is sheet resistivity of the N$^+$ region 6, $l$ is the length of the resistor strip, w is the width of the diffusion layer, and R is the resistance of the resistor.

Such resistors can be fabricated using photolithography and selective diffusion techniques for example, both fundamental processes of semiconductor device manufacture.

Generally resistors as seen in Fig. 3(b) are fabricated to have equal resistance values of R. To provide 2R resistors in a resistance network, R resistors are connected in series. Sometimes resistors are fabricated all with a resistance value equal to 2R, and R resistors provided by connecting two 2R resistors in parallel. These methods are preferable for fabricating resistors of resistance values precisely equal to R and 2R.

After the resistors 6 have been fabricated, the surface of the substrate is coated with a phosphosilicate glass (PSG) layer 7, for surface passivation. Contact windows are opened in appropriate positions on PSG layer 7, and the circuit is completed by connecting the resistors appropriately to aluminium wiring 8 and 9, as shown in Fig. 3(a). In Fig. 3(b), the aluminium wiring 8 and 9, and the PSG layer 7 are not shown, more clearly to illustrate the alignment of resistor strips.

In order to integrate a D/A converter into an IC die, it is necessary to fabricate the resistors very precisely. This increases the difficulty of the manufacturing process and decreases yield. However, the most disagreeable problem is that the resistance value of a resistor fabricated in an IC die varies in accordance with bias voltage applied to the substrate of the IC. That is, in operation the resistance value varies from a nominal value in dependence upon the substrate bias voltage. This is an inevitable and inherent characteristic of MOS structured devices.

Usually an n-type resistor (which is made of n-type conductivity semiconductor) for a CMOS (complementary MOS) transistor, is used with a bias voltage applied to the substrate. For example, as shown in Fig. 3(a), the substrate is biased to 5 volts. The electrode 8 is also biased to 5 volts whilst the electrode 9 is grounded. Thus, the electric potential of the electrode 8 is zero and the electric potential of electrode 9 is −5 volts, with respect to the substrate 2.

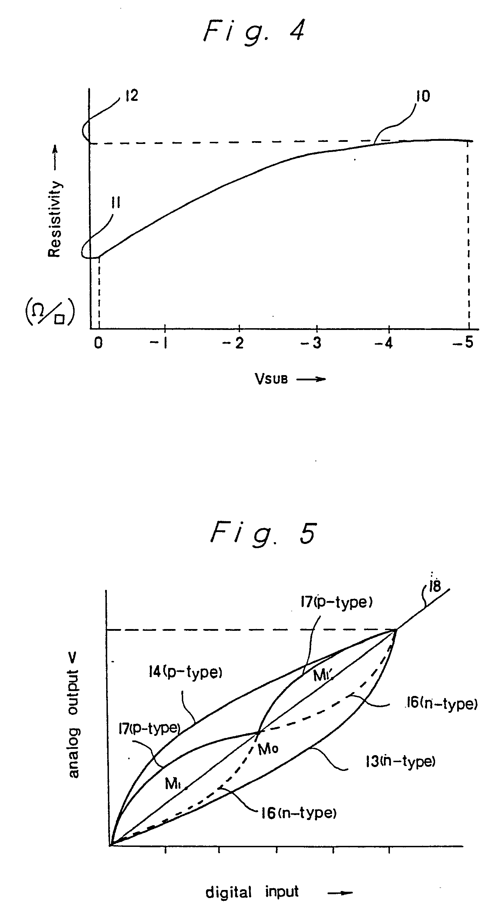

The resistivity of an n-channel conductive path (resistor) varies as shown by curve 10 in the graph shown in Fig. 4 of the accompanying drawings, when the substrate bias voltage is varied. This effect is due to variation of channel depth which occurs when the bias voltage is varied. More details of this phenomena are given, for example, in "Analog Integrated Circuit Design", by A. B. Grebne, published in 1972, by Litton Educational Publishing Inc.

Thus, sheet resistivity of a resistor (n$^+$ layer) close to the electrode 8, where it is biased nearly to 0 volt with respect to the substrate 2, is low. This is shown by point 11 in Fig. 4. However sheet resistivity of the resistor close to the electrode 9, where it is biased to −5 volt with respect to the substrate 2, is high. This is shown by point 12 in Figure 4. The sheet resistivity at points between the electrodes 8 and 9, changes from low value at point 11 gradually to the high value of point 12, as the location of the points shifts away from electrode 8 towards electrode 9.

It is, therefore, difficult to fabricate precisely the resistors R and 2R as determined by equations (1) and (2), because they are affected by the bias voltage applied to the substrate. Consequently a D/A converter as shown in Fig. 2, having a resistor network fabricated on the same IC substrate, exhibits a non-linear input-output characteristics as shown by curve 13 in the graph of Fig. 5 of the accompanying drawings.

The curve 13 shows characteristics of a D/A converter having an n-type conductivity resistance network. A D/A converter having a p-type conductivity resistance network exhibits characteristics as indicated by curve 14 in Fig. 5. The characteristics illustrated by curves 13 and 14 are effectively reversed because p-type conductivity and n-type conductivity are provided by holes and electrons respectively.

Such non-linear characteristics have been regarded in practice as inevitable, the result of an inherent defect of integrated circuit D/A converters comprising semiconductor ladder type networks. The non-linearity of analog output signal as against digital input signal has been inevitable for previous D/A converters, and this has been regarded as unavoidable.

Attention is directed to EP—A—0 026 529 which discloses a digital-analog converter with an R-2R resistance ladder network and switching circuit configuration corresponding to the configuration of Fig. 2.

EP—A—0 028 695 discloses a digital-analog converter with an R-2R resistance ladder network and a switching circuit configuration, in which resistances are constituted by MOS transistors.

According to the present invention there is provided an integrated circuit digital-analog converter, formed on a substrate which, when the integrated circuit is in operation, receives a substrate bias voltage, the converter comprising:

a resistance network comprising resistors constituted by p or n-type conductive semiconductor channels embedded in semiconductor material of opposite conductivity type, with at least one first resistor connected, connected in series when more than one first resistor is provided, between an output terminal of the converter and a second, terminating, resistor, the output terminal and the or each connecting point between those resistors constituting respective branch points of the network,

a plurality of switching circuits, connected to respective branch points, operable to supply respective branch points from a first supply voltage level, or from a second supply voltage level, in dependence upon the values of respective bits of a digital signal input to the converter, characterised in that:

at least one of the switching circuits has a configuration including third and fourth resistors, also constituted by p or n-type conductive channels embedded in semiconductor material of opposite conductivity type, and operable such that the branch point connected to the switching circuit concerned is supplied from the first supply voltage level through the third resistor and is supplied from the second supply voltage level through the fourth resistor, and wherein the nominal resistance of the or each third resistor differs slightly from the nominal resistance of the or each fourth resistor thereby to compensate for the effect of substrate bias voltage on the resistances of the resistors, when the integrated circuit is in operation, both those nominal resistances being close to twice the resistance of the or each first resistor, and the terminating resistor having the same resistance as the or a third resistor or as the or a fourth resistor, or a resistance twice that of the or a first resistor.

An embodiment of the present invention can provide an integrated circuit D/A converter offering improved linearity of the output analog signal against the input digital signal.

An embodiment of the present invention can provide a D/A converter fabricated in an IC in which output signal distortion is reduced. In particular, the effect of bias voltage applied to the substrate of a ladder circuit type (R-2R ladder network type) D/A converter can be mitigated or eliminated.

An embodiment of the present invention can provide simply and easily for improvement of the linearity of a D/A converter.

An embodiment of the present invention can provide a D/A converter which is easy to manufacture and offers increased production yield.

Briefly, in an embodiment of the present invention a pair of complementary MOS transistors in a ladder type D/A converter circuit, a p-type and an n-type MOS transistor, are divided and the transistors of the pair are provided with resistors of different resistance values connected with the resistance network of the converter. The D/A converter has such a divided CMOS (complementary MOS) transistor pair provided in respect of (for switching) at least the most significant bit (MSB) of a digital input signal. If necessary, such divided CMOS pairs are provided in respect of (in switching circuits for) bits of lesser significance.

Adjustment of the resistance network to reduce the non-linearity of the D/A converter is effected by altering the length or width, for example, of resistors associated with (included in) above-mentioned divided CMOS circuit pair.

Reference is made, by way of example, to the accompanying drawings, in which:—

Fig. 1 is a schematic block circuit diagram of a previous D/A converter;

Fig. 2 is a schematic circuit diagram of a realization of the D/A converter of Fig. 1 on an IC die;

Fig. 3(a) is a schematic cross sectional view of a semiconductor substrate illustrating the structure of a resistor as used in the D/A converter of Fig. 2;

Fig. 3(b) is a schematic plan view of resistors as used in the D/A converter of Fig. 2, showing their shapes and alignment on the IC die;

Fig. 4 is a graph illustrating characteristics of a resistor structured as in Fig. 3(a) of a conductive semiconductor layer, showing variation of resistor resistivity versus applied bias voltage;

Fig. 5 is a graph illustrating analog output voltage versus digital input signal, for comparing characteristics of embodiments of the present invention to the characteristic of the circuit of Fig. 2 and an ideal characteristic;

Fig. 6 is a schematic diagram of D/A converter embodying the present invention; and

Fig. 7 is a schematic circuit diagram of another D/A converter embodying the present invention.

Embodiments of the present invention can provide D/A converters offering improved linearity of output analog signal versus input digital signal.

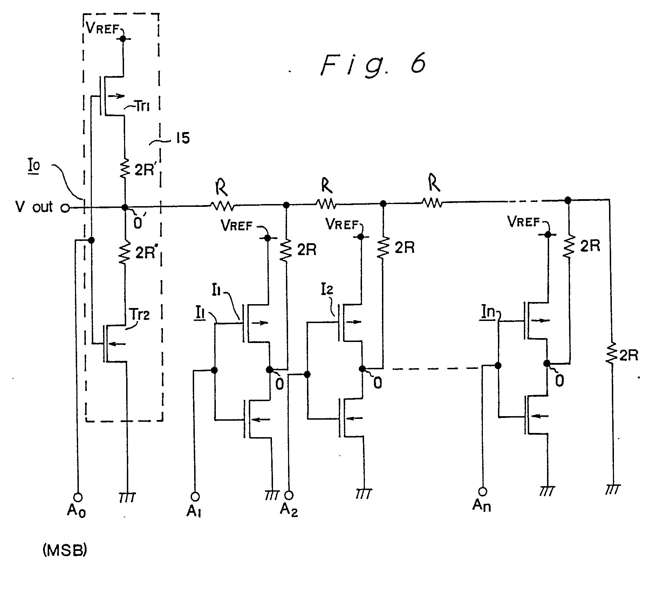

Fig. 6 is a schematic circuit diagram of one embodiment of the present invention. In Figure 6, like reference characters designate parts like or corresponding to parts shown in foregoing Figures. In comparison with Fig. 2, a difference is clear. This difference appears in regard to the first inverter $I_0$, which is surrounded by a broken-line rectangle in Fig. 6. In the embodiment of the present invention a circuit module 15, shown surrounded by a broken line in Fig. 6, replaces a $T_{r1}$, $T_{r2}$, 2R circuit configuration of Fig. 2. The remainder of the circuit of Fig. 6 is the same as that of Fig. 2.

A circuit module 15 as shown within the broken-line rectangle is applied in many varied embodiments of the present invention, as will be described hereinafter.

As shown in Fig. 6, in the circuit module 15, between the transistors of the complementary MOS (CMOS) transistor pair $T_{r1}$ and $T_{r2}$, which constitute the first inverter $I_0$ in Fig. 2, there are connected to two resistors 2R′ and 2R″, which are connected in series with one another. Thus the transistors of the pair are divided by 2R′ and 2R″, which are of different resistance values. The drain electrode of the p-MOS (p-type MOS) transistor $T_{r1}$ is connected to the resistor 2R′, and the source electrode of n-MOS (n-type MOS) transistor $T_{r2}$ is connected to the resistor 2R''. The gate electrodes of the two transistors $T_{r1}$ and $T_{r2}$ are connected to one another, and commonly connected to the input terminal $A_0$ which is fed with the MSB (most significant bit) of a digital input signal. The source electrode of the first transistor $T_{r1}$ is connected to reference voltage source $V_{REF}$, and the drain electrode of the second transistor $T_{r2}$ is grounded. A common point O', the junction point of resistors 2R' and 2R'', is connected to the remainder of the resistance network and to an output terminal of the converter.

As will be appreciated, in the circuit of Fig. 2, the output of inverter $I_0$ is supplied through the resistor 2R both when the p-MOS transistor is "ON", and when the n-MOS transistor is "ON". However, in the circuit module 15 of Fig. 6, when the transistor $T_{r1}$ is "ON", the output signal of the first inverter is delivered through first resistor 2R', and when the transistor $T_{r2}$ is "ON" the output signal is delivered through second resistor 2R''.

If the (nominal) resistances of resistors 2R' and 2R'' are adjusted beforehand, so as (in operation) to compensate for the effects of bias voltage, it is possible to eliminate non-linear effects arising from the bias voltage.

For instance, when the p-MOS transistor $T_{r1}$ is "ON", the resistance of resistor 2R' shifts e.g. to the right on the curve 10 in Fig. 4, so an adjustment in advance should be made to reduce the resistance of 2R'. On the other hand, when the n-MOS transistor $T_{r2}$ is "ON", the resistance of the resistor 2R' shifts e.g. to the left on the curve in Fig. 4, and adjustment in advance should therefore be made to increase the resistance of 2R''.

Since the circuit is driven digitally on and off, the bias voltages suffered by the resistors 2R' and 2R'' take fixed values. These values are determined by circuit design, and they are known in advance. Therefore, appropriate adjustment of the resistors can readily be determined. Adjustment can be effected by simply adjusting the length or width of the resistor strips. It is possible also to adjust resistance by varying diffusion dose of the resistor strips.

In Figure 6, a circuit module 15 is provided only for the first inverter $I_0$, which deals with the most significant bit of a digital input signal. It is very effective to improve linearity in respect to the MSB alone because as can be appreciated from equation (1) the effect of non-linearity in relation to the MSB is equal to total effect of non-linearity in relation to the remaining bits.

In the graph of Fig. 5 curves are shown to illustrate the improved characteristics offered by a D/A converter as shown in Fig. 6 (i.e. in which non-linearity in relation only to the MSB, the first inverter circuit $I_0$, is suppressed). In Fig. 5 characteristics of analog signal output voltage versus input digital signal are given in comparison with a circuit as shown in Fig. 2. Curve 17 illustrates the improved characteristic of a D/A converter using a p-type conductive resistance network, and the broken-line curve 16 illustrates the improved characteristics of a D/A converter using an n-type conductive resistance network. Curves 13 and 14 show the characteristics of D/A converters generally as illustrated in Fig. 2, using respectively an n-type and a p-type conductive resistance network.

As previously mentioned, the effect of the MSB is equal to the total effect of remaining bits, and the curves 16 and 17 will be seen to coincide with a straight line 18, which indicates ideal characteristics, at a middle point in the graph of Fig. 5. The gaps between the line 18 and the curves 16 or 17, away from the middle point, are due to the effects of the remaining bits which in the circuit of Fig. 6 do not have circuit modules 15 such as provided for the MSB. The circuit of Fig. 6, using p-type conductive resistors or n-type conductive resistors, exhibits two upward convex points or two downward concave points respectively, in the characteristics, as shown in the graph of Fig. 5.

The reason for the difference between the characteristics relating to p-type conductive resistance networks and n-type conductive resistance networks is the fact that the conductivity of the former is controlled by holes whilst the conductivity of the latter is controlled by electrons.

As can be appreciated from the above description, if a circuit as shown in Fig. 6 for inverter $I_0$, that is circuit module 15, is applied also to the second inverter $I_1$, the linearity of the analog output signal is further improved. In this case characteristic curves corresponding to the curves 16 and 17 in Fig. 5 will coincide to the ideal line 18 at three points:— at point $M_0$ in Fig. 5 (the point improved by the first inverter $I_0$) and two more points $M_1$ and $M_1'$ in Fig. 5, each located at the middle of an upward or downward loop made of curves 16 and 17, as shown in Fig. 5.

The improvement in linearity can be extended further and further. As the number of bits or inverters provided with circuit modules 15 increases, the number of points on the applicable characteristic curve which coincide with the ideal line increases proportionally to the square of that number of inverters. Moreover, maximum deviations between the characteristic curve and the ideal line decrease. Most effectively circuit modules 15 should be applied in turn to bits of successively lesser significance, from the MSB downwards (i.e. applied to inverters successively further away from the output terminal). This follows the significance of the input signals to those inverters. As can be understood from the equation (1) each application of a circuit module 15 affords an improvement in linearity corresponding to the order or significance of the bit handled by the module.

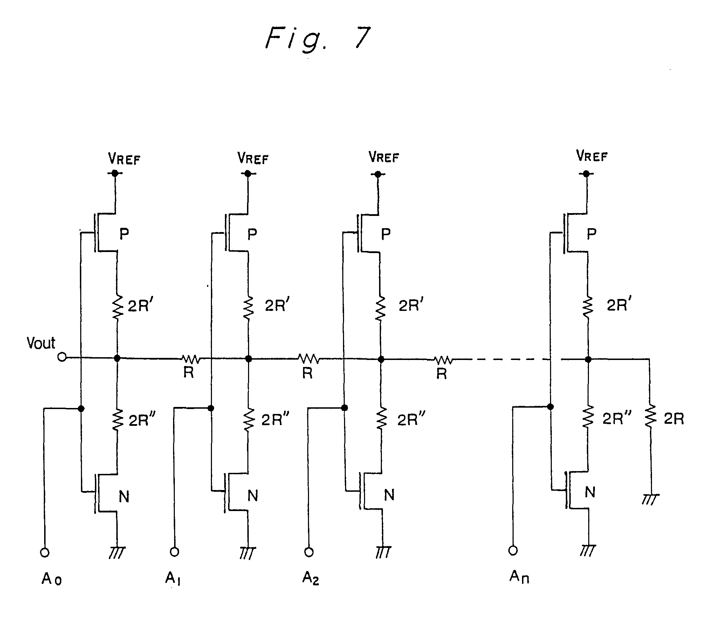

Fig. 7 shows another embodiment of the present invention. As can be seen in Fig. 7, circuit modules 15, corresponding to circuit module 15 in Fig. 6, are provided for all stages of the ladder circuit. In this case all resistors are of one or two kinds, 2R' and 2R'' resistors, except the termination resistor 2R.

It is easy to adjust the resistances of a number of resistors all at the same time with one process. Many varied practical methods can be employed. For example, elongating half the total number of resistor strips shown in Fig. 3(b), or broadening half the total number of resistor strips, and so on. Moreover, the termination resistor 2R can be replaced by a resistor 2R′ or a resistor 2R″ because the effect of that resistor is very small, and the difference of the resistance is negligible.

One example of resistor adjustment will be described. In a D/A converter circuit as shown in Fig. 2, the nominal resistances of resistors R and resistors 2R were respectively 25 KΩ and 50 KΩ. They were fabricated in strip form 10μ wide, 250μ long, and 10μ wide, 500μ long respectively. Sheet resistivity was 1 KΩ/square for the both R and 2R resistors. Adjustment was effected following a measurement of curves such as shown in Fig. 4, and appropriate calculations. The lengths of the resistor strips for resistors 2R′ and 2R″ shown in Fig. 6, were adjusted to 485μ and 520μ respectively. The width and the sheet resistivity were not changed. The adjustment of (nominal) resistance corresponds to 3% for 2R′ and 4% for 2R″ respectively. The curves (16, 17) shown in Fig. 5 were measured with a circuit as shown in Fig. 6 with resistors adjusted in this way.

As can be understood from the above description, the improvement afforded by circuit module 15 can be applied at any stage of a ladder circuit. However, it should be applied to the MSB stage first, and then to successively less significant stages in order. Increasing the number of stages so improved provides better linearity, but it increases the variety of resistors and difficulty of circuit design. Practically, a balance should be found between linearity requirements and circuit complexity or price.

The description above is given mainly with respect to silicon substrates but it will be clear that embodiments of the present invention can be applied for substrates of any material other than silicon. Many other variations are possible. For example, the MOS transistors as described may be replaced by other switching devices, or the p-MOS and n-MOS transistors shown in the drawings may be interchanged, and so on, all such variations being within the scope of the present invention.

An embodiment of the present invention provides a digital analog converter having a ladder circuit resistance network and switching means composed of p-channel and n-channel MOS transistors. The distortion of analog signals which is inherently generated due to nonlinear characteristics of resistors fabricated of p-channel or n-channel conductivity semiconductor is reduced. This is accomplished by replacing at least a module or stage of the ladder circuit by a T-type circuit element module, by adjusting the resistance values of the two side branches of the T-type circuit.

An embodiment of the present invention provides a digital analog converter comprising:

an output terminal to which output analog signal is provided;

a reference voltage source supplying a reference voltage;

a resistance circuit network, composed of plurality of first resistors connected in series each other, one end of said resistance network being connected to said output terminal, another end of said resistance network being terminated to ground through a second resistor, and each connection point of said resistors constituting a branching point arranged in a queue;

plurality of switching circuit individually connected to said output terminal and said branching points;

each of said switching circuit connects individually said branching points, to said reference voltage source or ground, corresponding to bit signal of said input digital signal,

at least one of said switching circuit being a circuit module, which connects said branching point to said reference voltage source through a third resistor, or connects said branching point to ground through a fourth resistor, corresponding to bit signal supplied to it.

Such a converter can be provided in which one of said circuit modulus being connected to said output terminal, and being controlled by most significant bit of input signal.

Such a converter can be provided in which all of said switching circuits being said circuit module.

Such a converter can be provided in which said circuit modules being connected to nearer side to said output terminal in said branching point queue, and each switching circuit being controlled by bit of said input digital signal corresponding to the order of significance.

Such a converter can be provided in which said circuit module of switching circuit, being composed of a p-channel and n-channel type MOS transistors and said third and fourth resistors;

gate electrode of each MOS transistor being connected to each other, and commonly fed by input digital signal,

source electrode of said p-channel MOS transistor being connected to said reference voltage source,

drain electrode of said p-channel MOS transistor being connected to said branching point through said third resistor,

source electrode of said n-channel MOS transistor being connected to said branching point through said fourth resistor;

drain electrode of said n-channel MOS transistor being connected to ground.

The resistors can be composed of p or n-type conductive semiconductor layer embedded in opposite type conductivity semiconductor.

Such a converter can be provided, in which resistance of said first resistors being equal to each other; resistance of said second resistor being twice of that of said first resistor; resistance of said third and fourth resistors being close to that of said second resistor, but a little different to each other.

It may be provided that if said resistors were made from p-type conductive layer, said resistance of said third resistor being smaller than that of said second resistor, and resistance of said fourth resistor being larger than that of said second resistor; and

If said resistors were made from n-type conductive layer, said resistance of said third resistor being larger than that of said second resistor, and resistance of said fourth resistor being smaller than that of said second resistor.

The resistor may be shaped in strips layed out parallel to each other.

All resistors may be composed of two kinds of resistors, said third and fourth resistors.

The p-type and n-type MOS transistors may replace each other, polarity of said reference voltage being reversed.

## Claims

1. An integrated circuit digital-analog converter, formed on a substrate which, when the integrated circuit is in operation, receives a substrate bias voltage, the converter comprising:
a resistance network comprising resistors (R, 2R) constituted by p or n-type conductive semiconductor channels embedded in semiconductor material of opposite conductivity type, with at least one first resistor (R) connected, connected in series when more than one first resistor (R) is provided, between an output terminal (Vout) of the converter and a second, terminating, resistor (2R), the output terminal (Vout) and the or each connecting point between those resistors constituting respective branch points of the network,
a plurality of switching circuits (I0 to In), connected to respective branch points, operable to supply respective branch points from a first supply voltage level (VREF), or from a second supply voltage level, in dependence upon the values (1 or 0) of respective bits (A0 to An) of a digital signal input to the converter, characterised in that:
at least one of the switching circuits (I0) has a configuration including third (2R') and fourth (2R'') resistors, also constituted by p or n-type conductive channels embedded in semiconductor material of opposite conductivity type, and operable such that the branch point (Vout, 0') connected to the switching circuit (I0) concerned is supplied from the first supply voltage level (VREF) through the third resistor (2R') and is supplied from the second supply voltage level through the fourth resistor (2R''), and wherein the nominal resistance of the or each third resistor (2R') differs slightly from the nominal resistance of the or each fourth resistor (2R'') thereby to compensate for the effect of substrate bias voltage on the resistances of the resistors, when the integrated circuit is in operation, both those nominal resistances being close to twice the resistance of the or each first resistor (R), and the terminating resistor (2R) having the same resistance as the or a third resistor (2R') or as the or a fourth resistor (2R''), or a resistance twice that of the or a first resistor (R).

2. A converter as claimed in claim 1, wherein the said one of the switching circuits (I0) is operable to supply the branch point (Vout, 0') connected thereto, from the first supply voltage level (VREF) or from the second supply voltage level, in dependence upon the value of the most significant bit (A0) of the digital signal input to the converter.

3. A converter as claimed in claim 2, wherein each switching circuit (I0 to In) of the plurality has the said configuration.

4. A converter as claimed in claim 1, wherein switching circuits (I0, I1) of the plurality connected to branch points corresponding to the output terminal (Vout) and to one or more of said connecting points neighboring the output terminal (Vout) in the resistance network have the said configruation.

5. A converter as claimed in any preceding claim, wherein the said configuration further includes a p-channel MOS transistor (Tr1) and an n-channel MOS transistor (Tr2), the gates of the MOS transistors being connected in common to receive a bit (A0 to An) of the digital signal input to the converter, the source of the p-channel MOS transistor (Tr1) being connected for receiving the first supply voltage level (VREF), the drain of the p-channel MOS transistor (Tr1) being connected to the relevant branch point (0') via said third resistor (2R'), the source of the n-channel MOS transistor (Tr2) being connected to the relevant branch point (0') via said fourth resistor, and the drain of the n-channel MOS transistor (Tr2) being connected for receiving the second supply voltage level.

6. A converter as claimed in any preceding claim, wherein the first supply voltage level (VREF) is a positive level and the second supply voltage level is ground, and wherein if the resistors (R, 2R, 2R', 2R'') are p-type conductive channels, the nominal resistances of the third (2R') and fourth (2R'') resistors are respectively lesser and greater than the resistance of the terminating resistor (2R), and wherein if the resistors (R, 2R, 2R', 2R'') are n-type conductive channels, the nominal resistances of the third (2R') and fourth (2R'') resistors are respectively greater and lesser than the resistance of the terminating resistor (2R).

7. A converter as claimed in any preceding claim, wherein the resistor channels are each strip-shaped and are laid out in parallel to one another.

8. A converter as claimed in any preceding claim, wherein all resistors are provided from two basic resistor types, corresponding to the third and fourth resistors respectively.

## Patentansprüche

1. Integrierter Digital-Analog-Konverter, der auf einem Substrat gebildet ist, welches, wenn die integrierte Schaltung in Betrieb ist, eine Substratvorspannung empfängt, welcher Konverter umfaßt:

ein Widerstandsnetzwerk, das Widerstände (R, 2R) umfaßt, die durch p- oder n-Typ-leitende Halbleiterkanäle gebildet sind, die in Halbleitermaterial von entgegengesetzten Leitfähigkeitstyp eingebeitet sind, mit wenigstens einem angeschlossenen ersten Widerstand (R), der, wenn mehr als ein erster Widerstand (R) vorgesehen ist, in Reihenverbindung, zwischen einem Ausgangsanschluß (Vout) des Konverters und einem zweiten, abschließenden Widerstand (2R) verbunden ist, wobei der Ausgangsanschluß (Vout) und der oder jeder Verbindungspunkt zwischen jeden Widerständen jeweilige Verzweigungspunkte des Netzwerkes bilden,

eine Vielzahl von Schaltkreisen (I0 bis In), die mit jeweiligen Verzweigungspunkten verbunden und betreibbar sind, um die jeweiligen Verzweigungspunkte, in Abhängigkeit von dem Wert (1 oder 0) der jeweiligen Bits (A0 bis An) eines digitalen Signaleingangs des Konverters von einem ersten Versorgungsspannungspegel (VREF) oder von einem zweiten Versorgungsspannungspegel zu versorgen, dadurch gekennzeichnet, daß

wenigstens einer der Schaltkreise (I0) eine Konfiguration hat, die dritte (2R') und vierte (2R'') Widerstände hat, die auch durch p- oder n-Typ-leitende Kanäle gebildet sind, die in dem Halbleitermaterial von entgegengesetztem Leitfähigkeitstyp eingebettet und so betriebbar sind, die der Verzweigungspunkt (Vout, 0'), der mit dem betreffenden Schaltkreis (I0) verbunden ist, von dem ersten Versorgungsspannungspegel (VREF) über dem dritten Widerstand (2R') versorgt wird und von dem zweiten Versorgungsspannungspegel über den vierten Widerstand (2R'') versorgt wird, und bei der der nominelle Widerstand von dem oder jedem dritten Widerstand (2R') von dem nominellen Widerstand von dem oder jedem vierten Widerstand (2R'') geringfügig verschieden ist, um dadurch die Effekte der Substratvorspannung auf die Widerstandswerte der Widerstände zu kompensieren, wenn die integrierte Schaltung in Betrieb ist, bei der jene beiden nominellen Widerstände nahe dem zweifachen des Widerstands von jedem ersten Widerstand (R) sind und der abschließende Widerstand (2R) denselben Widerstand hat, wie der oder ein dritter Widerstand (2R') oder wie der oder ein vierter Widerstand (2R''), oder einen Widerstand, der zweimal so groß wie derjenige des oder eines ersten Widerstands (R) ist.

2. Konverter nach Anspruch 1, bei dem der genannte eine der Schaltungskreise (I0) betreibbar ist, um den Verzweigungspunkt (Vout, 0'), der mit ihm verbunden ist, von dem ersten Versorgungsspannungspegel (VREF) oder von dem zweiten Versorgungsspannungspegel zu verzorgen, in Abhängigkeit von dem Wert des größten signifikanten Bit (A0) des digitalen Signaleingangs des Konverters.

3. Konverter nach Anspruch 2, bei dem jeder Schaltkreis (I0 bis In) der genannten Vielzahl die genannte Konfiguration hat.

4. Konverter nach Anspruch 1, bei dem die Schaltkreise (I0, I1) der genannten Vielzahl, die mit dem Verzweigungspunkten, die dem Ausgangsanschluß (Vout) entsprechen, und mit einem oder mehreren der genannten Verbindungspunkte verbunden sind, die dem Ausgangsanschluß (Vout) in dem Widerstandsnetzwerk benachbart sind, dieselbe Konfiguration haben.

5. Konverter nach einem der vorhergehenden Ansprüche, bei dem die genannte Konfiguration ferner einen p-Kanal-MOS-Transistor (Tr1) und einen n-Kanal-MOS-Transistor (Tr2) umfaßt, wobei die Gates der MOS-Transistoren gemeinsam verbunden sind, um ein Bit (A0 bis An) des digitalen Signaleingangs des Konverters zu empfangen, die Source des p-Kanal-MOS-Transistors (Tr1) angeschlossen ist, um den ersten Versorgungsspannungspegel (VREF) zu empfangen, das Drain des p-Kanal-MOS-Transistors (Tr1) mit dem relevanten Verzweigungspunkt (0') über den genannten dritten Widerstand (2R') verbunden ist, die Source des n-Kanal-MOS-Transistors (Tr2) mit dem relevanten Verzweigungspunkt (0') über den genannten vierten Widerstand verbunden ist, und das Drain des n-Kanal-MOS-Transistors (Tr2) angeschlossen ist, um den zweiten Versorgungsspannungspegel zu empfangen.

6. Konverter nach einem der vorhergehenden Ansprüche, bei dem der genannte erste Spannungspegel (VREF) ein positiver Pegel und der zweite Versorgungsspannungspegel Erde ist, und bei dem dann, falls die Widerstände (R, 2R, 2R', 2R'') Kanäle vom p-Leitfähigkeitstyp sind, die nominellen Widerstände des dritten (2R') und vierten (2R'') Widerstands jeweils kleiner bzw. größer als der Widerstand des abschließenden Widerstands (2R) sind, und bei dem dann, falls die Widerstände (R, 2R, 2R', 2R'') Kanäle vom n-Leitfähigkeitstyp sind, die nominellen Widerstände der dritten (2R') und vierten (2R'') Widerstände jeweils größer bzw. kleiner als der Widerstand des abschließenden Widerstands (2R) sind.

7. Konverter nach einem der vorhergehenden Ansprüche, bei dem die Widerstandskanäle jeweils streifenförmig und parallel zueinander ausgelegt sind.

8. Konverter nach einem der vorhergehenden Ansprüche, bei dem alle Widerstände aus zwei Basiswiderstandstypen bestehen, die den dritten bzw. vierten Widerständen entsprechen.

**Revendications**

1. Convertisseur numérique-analogique en circuit intégré, formé sur un substrat qui, quand le circuit intégré est en fonctionnement, reçoit une tension de polarisation de substrat, le convertisseur comportant:

un réseau de résistances comportant des résistances (R, 2R) constituées par des canaux semiconducteurs de conduction du type P ou du type N, encastrés dans une matière semi-conductrice du type de conductivité opposé avec au moins une première résistance (R) connectée, en série lorsque plus d'une première résistance (R) est prévue, entre une borne de sortie (Vout) de convertisseur et une seconde résistance de termination (2R), la borne de sortie (Vout) et le ou chaque point de connexion entre les résistances constituant des points de branchement respectifs du réseau,

plusieurs circuits de commutation (I0 à In) connectés aux points de branchement respectifs, ayant pour fonction d'alimenter des points de branchement respectifs à partir d'un premier niveau de tension d'alimentation (VREF) ou à partir d'un second niveau de tension d'alimentation en fonction de valeurs (1 ou 0) des bits respectifs (A0 à An) d'un signal numérique appliqué au convertisseur, caractérisé en ce que

l'un au moins des circuits de commutation (I0) a une configuration comprenant une troisième (2R') et une quatrième (2R'') résistances, également constituées par des canaux conducteur du type P ou du type N, encastrés dans une matière semiconductrice du type opposé de conductivité et ayant pour fonction que le point de branchement (Vout, 0') connecté au circuit de commutation (I0) concerné soit alimenté à partir du premier niveau de tension d'alimentation (VREF) par l'intermédiaire de la troisième résistance (2R') et soit alimenté à partir du second niveau de tension d'alimentation par l'intermédiaire de la quatrième résistance (2R'') et dans lequel la valeur nominale de la ou de chaque troisième résistance (2R') diffère légèrement de la valeur nominale de la ou de chaque quatrième résistance (2R'') de manière à compenser l'effet d'une tension de polarisation de substrat sur les valeurs des résistances quand le circuit intégré est en fonctionnement, les valeurs nominales étant voisines du double de la valeur de la ou de chaque première résistance (R) et la résistance de terminaison (2R) ayant la même valeur que la ou une troisième résistance (2R') ou la ou une quatrième résistance (2R'') ou une valeur double de la ou d'une première résistance (R').

2. Convertisseur selon la revendication 1, dans lequel ledit circuit de commutation (I0) a pour fonction d'alimenter le point de branchement (Vout, 0') qui lui est connecté à partir du premier niveau de tension d'alimentation (VREF) ou à partir du second niveau de tension d'alimentation en fonction de la valeur du bit le plus significatif (A0) du signal numérique d'entrée appliqué au convertisseur.

3. Convertisseur selon la revendication 2, dans lequel chaque circuit de commutation (I0 à In) parmi les plusieurs à ladite configuration.

4. Convertisseur selon la revendication 1, dans lequel des circuits de commutation (I0, I1) parmi les plusieurs connectés à des points de branchement correspondant à la borne de sortie (Vout) et à l'un ou plusieurs desdits points de connexion au voisinage de la borne de sortie (Vout) dans le réseau à résistances ont ladite configuration.

5. Convertisseur selon l'une quelconque des revendications précédentes, dans lequel ladite configuration comporte en outre un transistor MOS (Tr1) à canal P et un transistor MOS (Tr2) à canal N, les grilles des transistors MOS étant connectées en commun pour recevoir un bit (A0 à An) du signal numérique appliqué au convertisseur, la source du transistor MOS (Tr1) à canal P étant connectée pour recevoir le premier niveau de tension d'alimentation (VREF), le drain du transistor MOS (Tr1) à canal P étant connecté au point de branchement considéré (0') par ladite troisième résistance (2R'), la source du transistor MOS (Tr2) à canal N étant connectée au point de branchement considéré (0') par ladite quatrième résistance et le drain du transistor MOS (Tr2) à canal N étant connecté pour recevoir le second niveau de tension d'alimentation.

6. Convertisseur selon l'une quelconque des revendications précédentes, dans lequel le premier niveau de tension d'alimentation (VREF) est un niveau positif et le second niveau de tension d'alimentation est la masse et dans lequel, si les résistances (R, 2R, 2R', 2R'') sont des canaux conducteurs du type P, les valeurs nominales de la troisième (2R') et de la quatrième (2R'') résistances sont respectivement inférieure et supérieure à la valeur de la résistance de terminaison (2R) et dans lequel, si les résistances (R, 2R, 2R', 2R'') sont des canaux conducteurs du type N, les valeurs nominales de la troisième (2R') et de la quatrième (2R'') résistances sont respectivement supérieure et inférieure à la valeur de la résistance de terminaison (2R).

7. Convertisseur selon l'une quelconque des revendications précédentes, dans lequel les canaux résistants ont chacun la forme d'une bande et sont disposés parallèlement entre eux.

8. Convertisseur selon l'une quelconque des revendications précédentes, dans lequel toutes les résistances sont prévues à partir de deux types de résistances de base correspondant respectivement à la troisième et à la quatrième résistances.

*Fig. 1*

*Fig. 2*

1

*Fig. 3*

(a)

*Fig. 3*

(b)

## Fig. 4

## Fig. 5

3

Fig. 6

(MSB)

## Fig. 7